# EUROPEAN PATENT APPLICATION

(11) **EP 4 498 393 A1**
(43) Date of publication of application: **29.01.2025**
(21) Application number: 24186520.3
(22) Date of filing: 04.07.2024
(51) Int. Cl.: H01F 27/36, H05K 9/00

(54) **ELECTRONIC DEVICE AND MAGNETIC SHIELDING ELEMENT THEREOF**

(30) Priority: 28.07.2023 US 202363529428 P; 15.11.2023 CN 202311518758
(71) Applicant: Delta Electronics, Inc., Taoyuan City 33370 (TW)
(72) Inventor: Tsao, Yue, 32063 Taoyuan City (TW); Yen, Chun-Ching, 32063 Taoyuan City (TW); Peng, Hsien-Chun, 32063 Taoyuan City (TW)
(74) Representative: Uexküll & Stolberg

(57) **Abstract**

The present disclosure provides an electronic device (100, 101, 102, 103) and a magnetic shielding element (3, 3a, 3b) thereof. The electronic device (100, 101, 102, 103) includes a first component (1), a second component (2) and a magnetic shielding element (3, 3a, 3b). The first component (1) is an electronic component. The second component (2) disposed adjacent to the first component (1). At least a part of the magnetic shielding element (3, 3a, 3b) is disposed between the first component (1) and the second component (2). Consequently, the advantage of reducing the magnetic interference is achieved.

## Description

### FIELD OF THE INVENTION

The present disclosure relates to an electronic equipment, and more particularly to an electronic device with low magnetic interference and a magnetic shielding element thereof.

### BACKGROUND OF THE INVENTION

With the development and improvement of the technology, miniaturized electronic devices have become one of the current trends. The conventional electronic device, such as power adapter, usually includes a plurality of electronic components (such as transformer and inductor) and assembling components (such as casing). In order to achieve the purpose of miniaturization, the arrangement of the electronic components and the assembling components are designed to be relatively compact. However, the compacted arrangement would cause excessive magnetic interference among the plurality of electronic components. Moreover, if the electronic component is disposed closing to the assembling component, the magnetic interference from the electronic component would be reflected by the assembling component, so that the electronic component would still be affected by the magnetic interference.

In order to overcome the above-mentioned deficiencies, some of the conventional electronic devices further include copper plates. The copper plate is perpendicularly disposed between two electronic components, and the copper plate is grounded, so as to reduce the magnetic interference between the two electronic components. However, the perpendicular copper plate has large volume, which cannot satisfy the requirement of miniaturization, and increases the difficulty of the manufacturing process of the electronic device. In addition, the cost of the copper is high, and the flexibility of use is low.

In some conventional electronic devices, the casing (assembling component) thereof further includes an opening. The opening in disposed corresponding to the position of the electronic component. Due to the arrangement of the opening, the reflection from the casing is reduced. However, since the casing includes the opening, the heat dissipating area of the casing is reduced, and poor heat dissipation efficiency of the electronic device would be caused. Moreover, the arrangement of the opening needs extra manufacturing costs, and the manufacturing process is complicated.

Therefore, there is a need of providing an electronic device with low magnetic interference and a magnetic shielding element thereof to obviate the drawbacks encountered from the prior arts.

### SUMMARY OF THE INVENTION

It is an objective of the present disclosure to provide an electronic device with low magnetic interference and a magnetic shielding element thereof, which achieves the advantages of reducing the magnetic interference, easily assembling, high flexibility of use, reducing cost, enhancing heat dissipating efficiency, and fulfilling the requirements of miniaturization.

In accordance with an aspect of the present disclosure, there is provided an electronic device. The electronic device includes at least one first component, at least one second component and at least one magnetic shielding element. The at least one first component is an electronic component. The at least one second component is disposed adjacent to the at least one first component. At least a part of the at least one magnetic shielding element is disposed between the at least one first component and the at least one second component.

In accordance with another aspect of the present disclosure, there is provided a magnetic shielding element. The magnetic shielding element is applied for an electronic device. The electronic device includes a first component and a second component. The second component is disposed adjacent to the first component. At least a part of the magnetic shielding element is disposed between the first component and the second component.

### BRIEF DESCRIPTION OF THE DRAWINGS

FIG. 1 is a schematic top view illustrating an electronic device of a first embodiment of the present disclosure;
FIG. 2 is a partially enlarged view illustrating an area B of the electronic device of FIG. 1;
FIG. 3 is a partially cross-sectional view illustrating a magnetic shielding element of the electronic device of FIG. 1;
FIG. 4 is a schematic top view illustrating an electronic device of a second embodiment of the present disclosure;
FIG. 5 is a cross-sectional view illustrating an electronic device of a third embodiment of the present disclosure;
FIG. 6 is a partially enlarged view illustrating an area C of the electronic device of FIG. 5;
FIG. 7 is a schematic perspective view illustrating an electronic device of a fourth embodiment of the present disclosure;
FIG. 8 is an exploded view illustrating the electronic device of FIG. 7;
FIG. 9 is a partially cross-sectional view illustrating a magnetic shielding element of the electronic device of a variant embodiment of the present disclosure; and
FIG. 10 is a partially cross-sectional view illustrating a magnetic shielding element of the electronic device of another variant embodiment of the present disclosure.

### DETAILED DESCRIPTION OF THE PREFERRED EMBODIMENT

The present disclosure will now be described more specifically with reference to the following embodiments. It is to be noted that the following descriptions of preferred embodiments of this disclosure are presented herein for purpose of illustration and description only. It is not intended to be exhaustive or to be limited to the precise form disclosed.

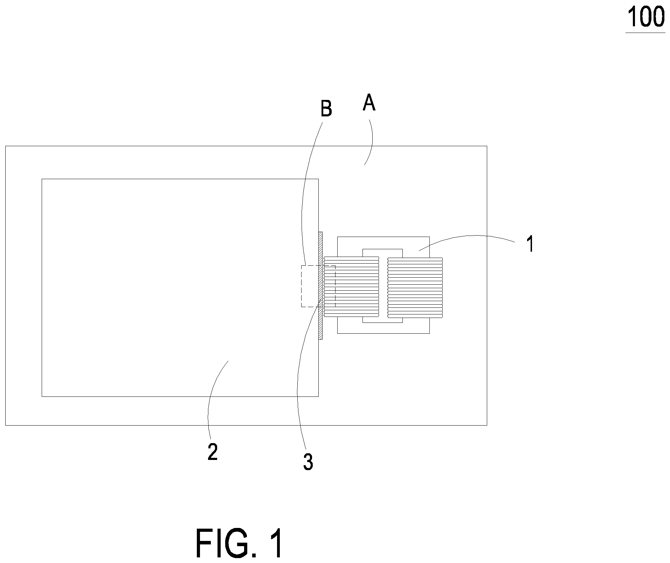

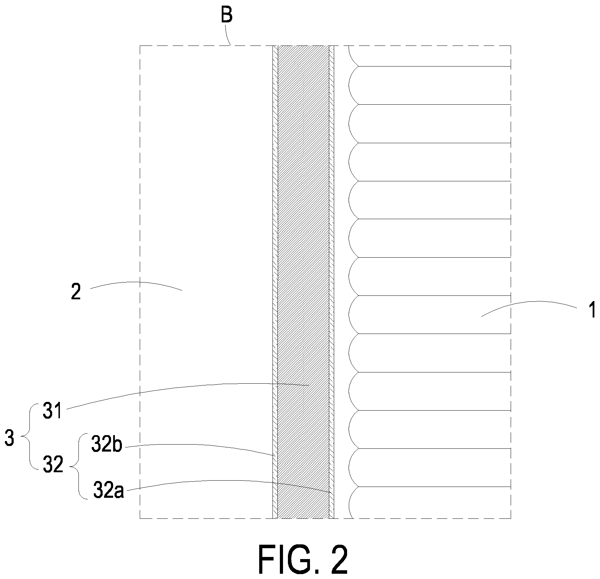

FIG. 1 is a schematic top view illustrating an electronic device of a first embodiment of the present disclosure, and FIG. 2 is a partially enlarged view illustrating an area B of the electronic device of FIG. 1. As shown in FIG. 1 and FIG. 2, the electronic device 100 of the present embodiment includes at least one first component 1, at least one second component 2 and at least one magnetic shielding element 3. For ease of understanding, the electronic device 100 of the present embodiment for example but not limited to include one first component 1, one second component 2 and one magnetic shielding element 3. The first component 1 is an electronic component, which for example but not limited to be an inductive component. The second component 2 is an electronic component, which for example but not limited to be a transformer. Both of the first component 1 and the second component 2 are disposed on the circuit board A. The second component 2 is disposed adjacent to a side of the first component 1. The magnetic shielding element 3 is disposed between the first component 1 and the second component 2. Since the magnetic shielding element 3 is disposed between the first component 1 and the second component 2, the interaction caused by the magnetic interference between the first component 1 and the second component 2 is reduced. In the present embodiment, the magnetic shielding element 3 is attached on the second component 2, but not limited thereto. In some embodiments, the magnetic shielding element 3 is attached on the first component 1, or is attached on the first component 1 and the second component 2 at the same time.

In the present embodiment, the magnetic shielding element 3 includes a magnetic shielding layer 31 and at least one insulation film 32. In the present embodiment, the at least one insulation film 32 includes a first insulation film 32a and a second insulation film 32b. The first insulation film 32a and the second insulation film 32b are attached on two opposite sides of the magnetic shielding layer 31, respectively. The first insulation film 32a is disposed on the side toward the first component 1, and the second insulation film 32b is disposed on the side toward the second component 2. Due to the arrangement of the first insulation film 32a and the second insulation film 32b of the magnetic shielding element 3, the insulating efficiency between the first component 1 and the second component 2 is enhanced.

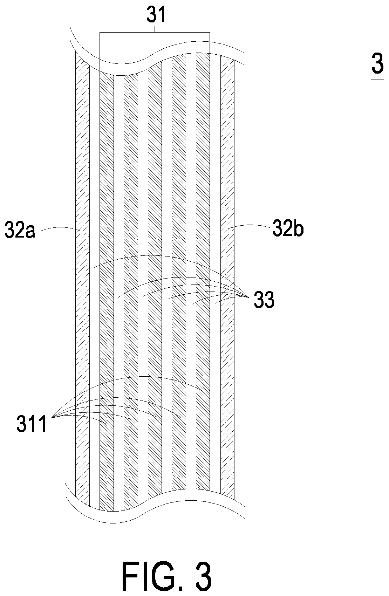

FIG. 3 is a partially cross-sectional view illustrating a magnetic shielding element of the electronic device of FIG. 1. As shown in FIG. 1 to FIG. 3, the magnetic shielding layer 31 of the magnetic shielding element 3 of the present embodiment includes a plurality of magnetic films 311. The plurality of magnetic films 311 are stacked and adhered with each other. In the present embodiment, the number of the magnetic films 311 is five, and the five magnetic films 311 are stacked and adhered with each other to form the magnetic shielding layer 31, but not limited thereto, the number of the magnetic films 311 can be adjusted according to the intensity of the magnetic interference. Two adjacent magnetic films 311 are adhered to each other by an adhesive layer 33. The adhesive layer 33 is for example but not limited to a double-sided tape. The first insulation film 32a and the second insulation film 32b are adhered to two opposite sides of the magnetic shielding layer 31 by adhesive layers 33, respectively. Since the magnetic shielding layer 31 includes stacked magnetic films 311, the strength of blocking magnetic interference of the magnetic shielding element 3 is increased. By comparing to the copper plate of the prior art, the magnetic shielding element 3 of the present embodiment has thinner thickness and lower cost, so that the advantages of saving space and reducing cost are achieved. In addition, the magnetic shielding element 3 of the present embodiment blocks the magnetic interference without grounding, the advantages of easily assembling and high flexibility of use are achieved.

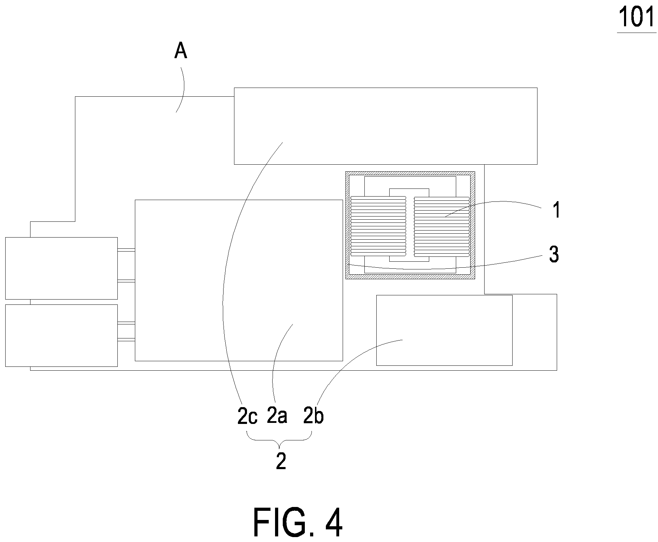

FIG. 4 is a schematic top view illustrating an electronic device of a second embodiment of the present disclosure. As shown in FIG. 4, the electronic device 101 of the present embodiment includes a first component 1, a plurality of second component 2 and a magnetic shielding element 3. In the present embodiment, the first component 1 for example but not limited to be an inductive component. The plurality of second components 2 are electronic components, and includes a first electronic component 2a, a second electronic component 2b and a third electronic component 2c. The first component 1, the first electronic component 2a, the second electronic component 2b and the third electronic component 2c are disposed on the same surface of the circuit board A. The first electronic component 2a, the second electronic component 2b and the third electronic component 2c are disposed corresponding to different sides of the first component 1. In the present embodiment, the magnetic shielding element 3 is a flexible sheet structure, and surrounds the periphery of the first component 1, so as to form a rectangular surrounding structure. Since the rectangular surrounding structure formed by the magnetic shielding element 3 surrounds the periphery of the first component 1, at least a part of the magnetic shielding element 3 is disposed between the first component 1 and the first electronic component 2a, at least a part of the magnetic shielding element 3 is disposed between the first component 1 and the second electronic component 2b, and at least a part of the magnetic shielding element 3 is disposed between the first component 1 and the third electronic component 2c. Due to the surrounding structure formed by the flexible magnetic shielding element 3, the magnetic interference among the first component 1 and the plurality of second components 2 are reduced. The first component 1 includes a first surface, a second surface, a third surface, a fourth surface, a fifth surface and a sixth surface (not shown). In the present embodiment, the flexible magnetic shielding element 3 surrounds the first surface, the second surface, the third surface and the fourth surface of the first component 1. In other embodiment, the flexible magnetic shielding element 3 may surround the second surface, the fourth surface, the fifth surface and the sixth surface of the first component 1, or surround the first surface, the third surface, the fifth surface and the sixth surface of the first component 1, or surround the first surface, the second surface, the third surface, the fourth surface, the fifth surface and the sixth surface of the first component 1.

In some embodiments, the flexible magnetic shielding element 3 is formed into surrounding structures having different shapes according to practical requirements. The surrounding structure is for example but not limited to at least one selected from the group of circle, triangle, polygonal and irregular shape. Consequently, the advantage of high flexibility of assembling is achieved.

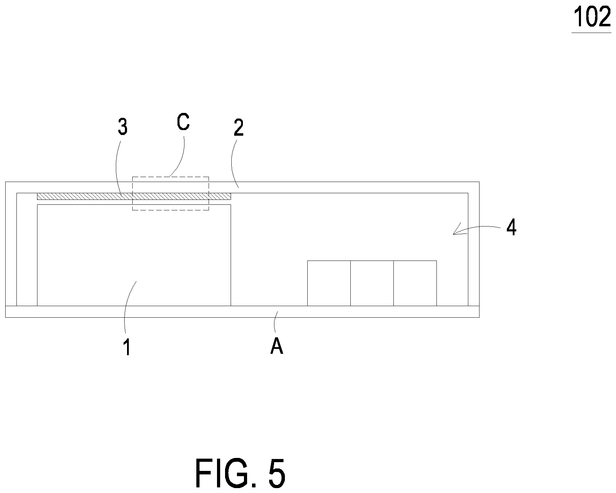

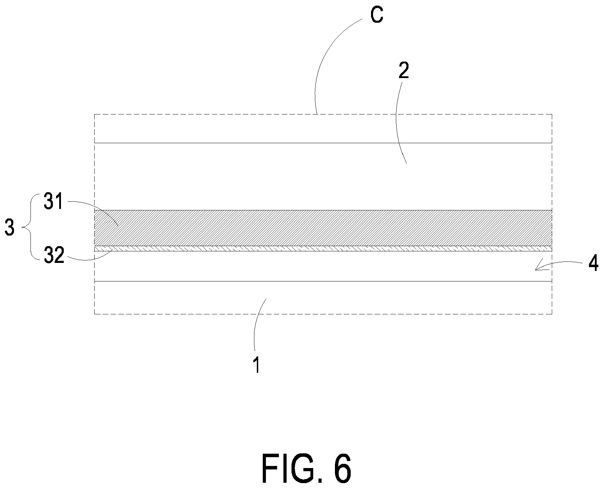

FIG. 5 is a cross-sectional view illustrating an electronic device of a third embodiment of the present disclosure, and FIG. 6 is a partially enlarged view illustrating an area C of the electronic device of FIG. 5. As shown in FIG. 5 and FIG. 6, the electronic device 102 of the present embodiment includes a first component 1, a second component 2 and a magnetic shielding element 3. In the present embodiment, the first component 1 is for example but not limited to an inductive component. The second component 2 is a non-electronic component, for example but not limited to a casing having the function of heat dissipating. The circuit board A is covered by the casing (the second component 2), and an accommodation space 4 is formed between the casing and the circuit board A. The first component 1 is disposed on the circuit board A, and is accommodated in the accommodation space 4. The magnetic shielding element 3 is disposed in the accommodation space 4, and includes a magnetic shielding layer 31 and an insulation film 32. The insulation film 32 of the magnetic shielding element 3 is attached on a side of the magnetic shielding layer 31. The insulation film 32 is disposed toward the first component 1, and the magnetic shielding layer 31 is disposed toward the second component 2. Since the magnetic shielding element 3 is disposed between the first component 1 and the second component 2, the magnetic interference generated from the first component 1 is prevented from reflecting by the second component 2, and the advantage of reducing magnetic interference is achieved. By comparing to the prior art, the magnetic shielding element 3 of the present embodiment achieves the advantage of reducing magnetic interference without disposing an opening on the casing. Due to the casing without openings has a larger heat dissipation area, the heat dissipation efficiency is increased. In the present embodiment, the magnetic shielding layer 31 of the magnetic shielding element 3 is directly attached on a surface of the second component 2, but not limited thereto.

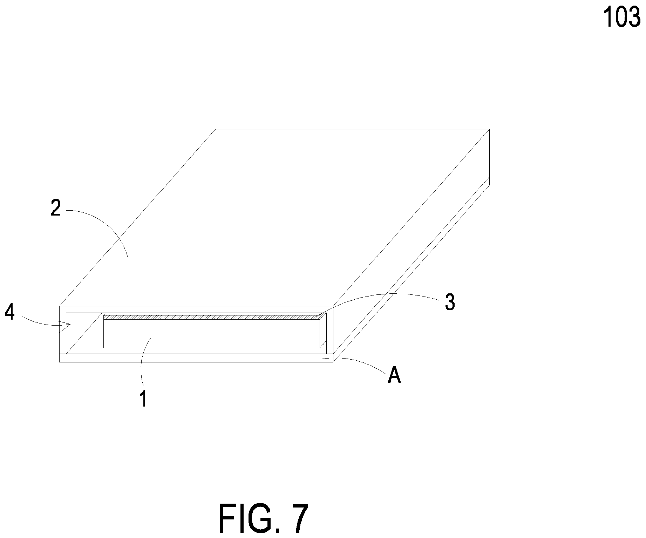

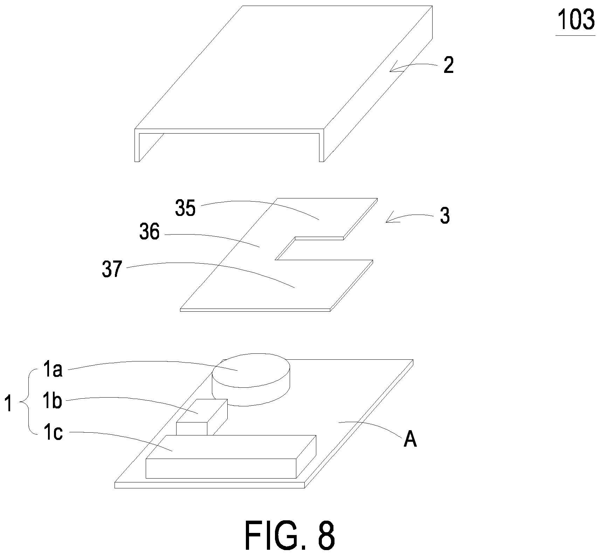

FIG. 7 is a schematic perspective view illustrating an electronic device of a fourth embodiment of the present disclosure, and FIG. 8 is an exploded view illustrating the electronic device of FIG. 7. As shown in FIG. 7 and FIG. 8, the electronic device 103 of the present embodiment includes a plurality of first components 1, a second component 2 and a magnetic shielding element 3. In the present embodiment, the plurality of first components 1 are electronic devices, and include a first electronic component 1a, a second electronic component 1b and a third electronic component 1c. The second component 2 is a non-electronic component, for example but not limited to a casing having the function of heat dissipating. The circuit board A is covered by the casing (the second component 2), and an accommodation space 4 is formed between the casing and the circuit board A. The first electronic component 1 a, the second electronic component 1b and the third electronic component 1c are disposed on the same surface of the circuit board A, respectively, and accommodated in the accommodation space 4. The first electronic component 1a is disposed adjacent to a side of the second electronic component 1b, and the third electronic component 1c is disposed adjacent to another side of the second electronic component 1b. The magnetic shielding element 3 is disposed in the accommodation space 4, and is disposed between the plurality of first components 1 and the second component 2. The magnetic shielding element 3 includes a first portion 35, a second portion 36 and a third portion 37. The second portion 36 is in connection between the first portion 35 and the third portion 37. The magnetic shielding element 3 is attached on the second component 2, and is arranged above the first electronic component 1a, the second electronic component 1b and the third electronic component 1c. The first portion 35 is disposed corresponding to the position of the first electronic component 1a. The second portion 36 is disposed corresponding to the position of the second electronic component 1b. The third portion 37 is disposed corresponding to the position of the third electronic component 1c. Since the first portion 35, the second portion 36 and the third portion 37 of the magnetic shielding element 3 are disposed corresponding to the first components 1, the magnetic interference generated from the plurality of first components 1 is prevented from reflecting by the second component 2, and the advantage of reducing magnetic interference is achieved. In some embodiments, the shape of the magnetic shielding element 3 can be adjusted according to the shape and position of the first component 1, which is not limited to forgoing embodiments.

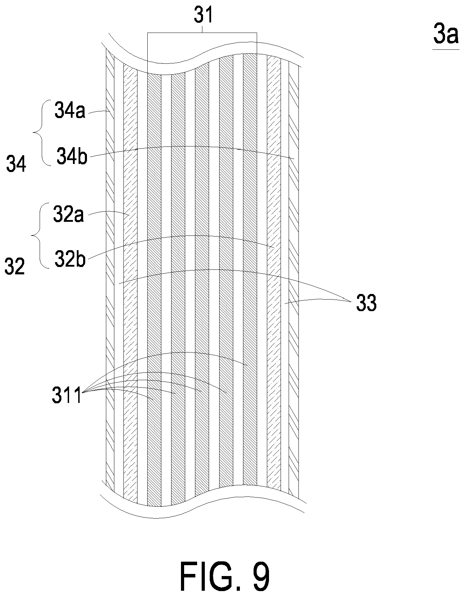

FIG. 9 is a partially cross-sectional view illustrating a magnetic shielding element of the electronic device of a variant embodiment of the present disclosure. The structure of the magnetic shielding element 3a of the present embodiment is similar to the magnetic shielding element 3 of FIG. 3, the same references represent the same components and functions, and they would not be repeatedly described hereinafter. Different from the magnetic shielding element 3 of FIG. 3, the magnetic shielding element 3a of the present embodiment includes at least one protection layer 34. The at least one protection layer 34 for example but not limited to be two protection layers 34, and include a first protection layer 34a and a second protection layer 34b. The first protection layer 34a is detachably disposed on the first insulation film 32a, and is arranged at a side of the magnetic shielding layer 31. The second protection layer 34b is detachably disposed on the second insulation film 32b, and is arranged at another side of the magnetic shielding layer 31. The first protection layer 34a and the second protection layer 34b are the two outermost layers of the magnetic shielding element 3a, respectively, configured for protecting the magnetic shielding layer 31 and the insulation film 32 from being damaged or stuck during transportation. In the present embodiment, the first protection layer 34a and the second protection layer 34b are attached on the first insulation film 32a and the second insulation film 32b by a double-sided tape, respectively, and are removed before the assembling process of the components, but not limited thereto. In the present embodiment, the at least one protection layer 34 of the magnetic shielding element 3a is for example but not limited to a release film.

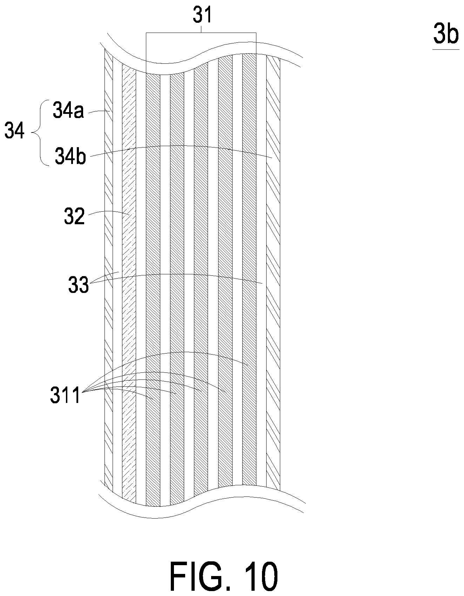

FIG. 10 is a partially cross-sectional view illustrating a magnetic shielding element of the electronic device of another variant embodiment of the present disclosure. The structure of the magnetic shielding element 3b of the present embodiment is similar to the magnetic shielding element 3a of FIG. 9, the same references represent the same components and functions, and they would not be repeatedly described hereinafter. Different from the magnetic shielding element 3a of FIG. 9, the first protection layer 34a of the at least one protection layer 34 of the magnetic shielding element 3b of the present embodiment is detachably disposed on the insulation film 32, and arranged at a side of the magnetic shielding layer 31. The second protection layer 34b is detachably attached on another side of the magnetic shielding layer 31 opposite to the insulation film 32. The first protection layer 34a and the second protection layer 34b are the two outermost layers of the magnetic shielding element 3, respectively, configured for protecting the magnetic shielding layer 31 and the insulation film 32 from being damaged or stuck during transportation. In the present embodiment, the first protection layer 34a and the second protection layer 34b are attached on the insulation film 32 and the magnetic shielding layer 31 by a double-sided tape, respectively, and are removed before the assembling process of the components, but not limited thereto. In the present embodiment, the at least one protection layer 34 of the magnetic shielding element 3b is for example but not limited to a release film.

From the above descriptions, the present disclosure provides an electronic device with low magnetic interference and a magnetic shielding element thereof. By arranging the magnetic shielding element between the first component and the second component, the magnetic interference therebetween is reduced. Due to the arrangement of the insulation film of the magnetic shielding element, the insulating efficiency between the components is enhanced. Due to the arrangement of the stacked magnetic films of the magnetic shielding layer, the strength of blocking magnetic interference is increased. By comparing to the copper plate of the prior art, the magnetic shielding element of the present disclosure has thinner thickness and lower cost, so that the advantages of saving space and reducing cost are achieved. Since the magnetic shielding element of the present disclosure can block the magnetic interference without grounding, the advantages of easily assembling and high flexibility of use are achieved. Since the magnetic shielding element is formed as the surrounding structure, or disposed corresponding to the electronic components, the magnetic interference among the plurality of electronic components are reduced. Since the protection layers are the outermost layers of the magnetic shielding element, the advantages of protecting the magnetic shielding element from being damaged or stuck during transportation are achieved.

## Claims

1. An electronic device (100, 101, 102, 103) **characterized by** comprising:
at least one first component (1), wherein the at least one first component (1) is an electronic component;
at least one second component (2) disposed adjacent to the at least one first component (1); and
at least one magnetic shielding element (3, 3a, 3b), wherein at least a part of the at least one magnetic shielding element (3, 3a, 3b) is disposed between the at least one first component (1) and the at least one second component (2).

2. The electronic device (100, 101, 102, 103) according to claim 1, wherein the at least one magnetic shielding element (3, 3a, 3b) is attached on at least one of the at least one first component (1) or the at least one second component (2), wherein the at least one magnetic shielding element (3, 3a, 3b) is a flexible sheet structure, and surrounds the periphery of the at least one first component (1) to form a surrounding structure, wherein the surrounding structure is at least one selected from the group of circle, triangle, polygonal and irregular shape.

3. The electronic device (100, 101, 102, 103) according to claim 1, wherein the at least one magnetic shielding element (3, 3a, 3b) comprises a magnetic shielding layer (31) and at least one insulation film (32), wherein a surface of the at least one insulation film (32) is attached on a side of the magnetic shielding layer (31), and the at least one insulation film (32) is disposed toward the at least one first component (1).

4. The electronic device (100, 101) according to claim 3, wherein the at least one second component (2) is an electronic component, wherein the at least one insulation film (32) of the at least one magnetic shielding element (3, 3a) comprises a first insulation film (32a) and a second insulation film (32b), wherein the first insulation film (32a) and the second insulation film (32b) are attached on two opposite sides of the magnetic shielding layer (31), respectively, wherein the first insulation film (32a) is disposed toward the at least one first component (1), and the second insulation film (32b) is disposed toward the at least one second component (2).

5. The electronic device (102, 103) according to claim 3, wherein the at least one second component (2) is a non-electronic component, wherein the at least one insulation film (32) of the at least one magnetic shielding element (3, 3a, 3b) is attached on a side of the magnetic shielding layer (31), wherein the at least one insulation film (32) is disposed toward the at least one first component (1), and the magnetic shielding layer (31) is disposed toward the at least one second component (2), wherein the magnetic shielding layer (31) of the at least one magnetic shielding element (3, 3a, 3b) is attached on the at least one second component (2).

6. The electronic device (100, 101, 102, 103) according to claim 3, wherein the magnetic shielding layer (31) of the at least one magnetic shielding element (3, 3a, 3b) comprises a plurality of magnetic films (311), wherein the plurality of magnetic films (311) are stacked and adhered with each other, wherein two adjacent magnetic films (311) are adhered to each other by a double-sided tape.

7. The electronic device (100, 101, 102, 103) according to claim 3, wherein the at least one magnetic shielding element (3a, 3b) comprises at least one protection layer (34), wherein the at least one protection layer (34) is detachably disposed on a side of the magnetic shielding layer (31) or the at least one insulation film (32), and is the outermost layer of the at least one magnetic shielding element (3a, 3b).

8. The electronic device (100, 101, 102, 103) according to claim 7, wherein the at least one protection layer (34) comprises a first protection layer (34a) and a second protection layer (34b), wherein the first protection layer (34a) and the second protection layer (34b) are detachable, and are two opposite outermost layers of the at least one magnetic shielding element (3a, 3b), wherein the at least one protection layer (34) of the at least one magnetic shielding element (3a, 3b) is a release film.

9. A magnetic shielding element (3, 3a, 3b) for an electronic device (100, 101, 102, 103), wherein the electronic device (100, 101, 102, 103) comprises a first component (1) and a second component (2), and the second component (2) is disposed adjacent to the first component (1), **characterized in that**:
at least a part of the magnetic shielding element (3, 3a, 3b) is disposed between the first component (1) and the second component (2).

10. The magnetic shielding element (3, 3a, 3b) according to claim 9, wherein the magnetic shielding element (3, 3a, 3b) is attached on at least one of the first component (1) or the second component (2), wherein the magnetic shielding element (3, 3a, 3b) is a flexible sheet structure, and surrounds the periphery of the first component (1) to form a surrounding structure, wherein the surrounding structure is at least one selected from the group of circle, triangle, polygonal and irregular shape.

11. The magnetic shielding element (3, 3a, 3b) according to claim 9, wherein the magnetic shielding element (3, 3a, 3b) comprises a magnetic shielding layer (31) and at least one insulation film (32), wherein a surface of the at least one insulation film (32) is attached on a side of the magnetic shielding layer (31), and the at least one insulation film (32) is disposed toward the first component (1).

12. The magnetic shielding element (3, 3a) according to claim 11, wherein the second component (2) is an electronic component, wherein the at least one insulation film (32) comprises a first insulation film (32a) and a second insulation film (32b), wherein the first insulation film (32a) and the second insulation film (32b) are attached on two opposite sides of the magnetic shielding layer (31), respectively, wherein the first insulation film (32a) is disposed toward the first component (1), and the second insulation film (32b) is disposed toward the second component (2).

13. The magnetic shielding element (3, 3a, 3b) according to claim 11, wherein the second component (2) is a non-electronic component, wherein the at least one insulation film (32) is attached on a side of the magnetic shielding layer (31), wherein the at least one insulation film (32) is disposed toward the first component (1), and the magnetic shielding layer (31) is disposed toward the second component (2), wherein the magnetic shielding layer (31) is attached on the second component (2).

14. The magnetic shielding element (3, 3a, 3b) according to claim 11, wherein the magnetic shielding layer (31) comprises a plurality of magnetic films (311), wherein the plurality of magnetic films (311) are stacked and adhered with each other, wherein two adjacent magnetic films (311) are adhered to each other by a double-sided tape.

15. The magnetic shielding element (3a, 3b) according to claim 11, wherein the magnetic shielding element (3a, 3b) comprises at least one protection layer (34), wherein the at least one protection layer (34) is detachably disposed on a side of the magnetic shielding layer (31) or the at least one insulation film (32), and is the outermost layer of the magnetic shielding element (3a, 3b), wherein the at least one protection layer (34) comprises a first protection layer (34a) and a second protection layer (34b), wherein the first protection layer (34a) and the second protection layer (34b) are detachable, and are two opposite outermost layers of the magnetic shielding element (3, 3a, 3b), wherein the at least one protection layer (34) of the at least one magnetic shielding element (3a, 3b) is a release film.
